# EUROPÄISCHE PATENTSCHRIFT

(11) **EP 3 874 216 B1**
(45) Veröffentlichungstag und Bekanntmachung des Hinweises auf die Patenterteilung: **28.08.2024**
(21) Anmeldenummer: 19794941.5
(22) Anmeldetag: 22.10.2019
(51) Int. Cl.: F26B 3/347, F26B 5/06

(54) **VORRICHTUNG UND VERFAHREN ZUM GEFRIERTROCKNEN**
DEVICE AND METHOD FOR FREEZE-DRYING
DISPOSITIF ET PROCÉDÉ DE LYOPHILISATION

(30) Priorität: 02.11.2018 DE 102018218758
(43) Veröffentlichungstag der Anmeldung: 08.09.2021
(73) Patentinhaber: OPTIMA pharma GmbH, 74523 Schwäbisch Hall (DE)
(72) Erfinder: REUTER, Stephan, 34132 Kassel (DE); TAMBOVZEV, Alexander, 35644 Hohenahr (DE); KOPP, Matthias, 35091 Cölbe (DE)
(74) Vertreter: Patentanwälte Ruff, Wilhelm, Beier, Dauster & Partner mbB
(86) Internationale Anmeldenummer: PCT/EP2019/078748
(87) Internationale Veröffentlichungsnummer: WO 2020/088993

(56) Entgegenhaltungen:
- CN-A- 106 720 293
- CN-A- 108 260 241
- CN-A- 108 311 072
- CN-A- 108 362 089
- US-A- 4 435 629

## Beschreibung

Die Erfindung betrifft eine Vorrichtung und ein Verfahren zum Gefriertrocknen.

Viele pharmazeutische Produkte sind in flüssiger Form entweder zu instabil oder besitzen eine unzureichende Lebenszeit. Gefriertrocknung, auch als Lyophilisation oder Sublimationstrocknung bezeichnet, ist ein Verfahren zur schonenden Trocknung derartiger Produkte, insbesondere von Pharmaprodukten oder Biotechprodukten, beispielsweise von Impfstoffe, oder von Lebensmitteln, beispielsweise zur Herstellung von Milchpulver.

Dabei wird das Produkt durch Entzug von Flüssigkeit unter bestimmten, produktspezifischen Bedingungen auf schonende Art in einen stabilen Zustand überführt. Bei der Flüssigkeit handelt es sich meistens um Wasser. Es sind jedoch auch andere Lösungsmittel denkbar.

Im Zusammenhang mit der Anmeldung wird als mit einem Lösungsmittel versehenes Produkt jede Zubereitung bezeichnet, welche sich für die Gefriertrocknung eignet. Dabei handelt es sich insbesondere um flüssige oder halbfeste wässrige Zubereitungen, wie beispielsweise Lösungen, Emulsionen oder Suspensionen.

Vor dem eigentlichen Trocknungsvorgang erfolgt ein Abkühlen und Einfrieren des Produkts, wobei üblicherweise das Produkt auf eine bestimmte Gefriertemperatur abgekühlt wird und die Gefriertemperatur bis zum Einfrieren des Lösungsmittelanteils des Produkts beibehalten wird. Ein Einfrieren erfolgt üblicherweise bei Atmosphärendruck. Das Einfrieren wird auch als Kristallisation bezeichnet. Der Beginn des Einfrierens wird als Keimbildung oder Nukleation bezeichnet.

Der auf das Einfrieren folgende Trocknungsvorgang kann in eine Primärtrocknung und eine Sekundärtrocknung unterteilt werden. Bei der Primärtrocknung wird ein Druck reduziert und das in dem Produkt enthaltene Lösungsmittel bei geringen Temperaturen, üblicherweise unter dem Gefrierpunkt, sublimiert. Bei der Sekundärtrocknung wird in dem Produkt nach der Primärtrocknung noch gebundenes Lösungsmittel verdampft. Bei diesem Prozess wird auch von Desorption gesprochen.

Eine Qualität des Gefriertrocknungsprozesses wird maßgeblich von einem zeitlichen Verlauf einer Temperatur des Produkts beeinflusst. Eine Wärmezufuhr, d.h. ein Erwärmen des Produkts, findet üblicherweise nicht bei Atmosphärendruck, sondern ausschließlich unter Vakuumbedingungen statt. Durch die stark verdünnte Atmosphäre in der evakuierten Trocknungskammer nimmt die Wärmeleitfähigkeit in der Gasphase ab.

Bekannte Gefriertrocknungsanlagen umfassen eine Trocknungs- oder Produktkammer, in welcher ein Kondensator angeordnet ist oder welche mit einer zweiten, einen Kondensator aufweisenden Kammer verbunden ist. In der Produktkammer sind üblicherweise mehrere, übereinander angeordnete Stellplatten vorgesehen, auf welchen Gefäße, insbesondere Vials, mit dem darin abgefüllten, zu trocknenden Produkt, platziert werden.

Eine Wärmezufuhr oder Wärmeabfuhr erfolgt üblicherweise über die Stellplatten. Ein Temperieren der Stellplatten erfolgt dabei durch ein in den Stellplatten strömendes Wärmeträgerfluid, beispielweise Silikonöl. Ein Wärmetransfer auf das Wärmeträgerfluid erfolgt mittels eines speziellen Kühl-/Heizmoduls. Ein Wärmeübergang zwischen einem durch die Stellplatten geführten Wärmeträgerfluid und den Produkten oder zwischen den Produkten und dem Wärmeträgerfluid stellt eine komplexe verfahrenstechnische Anforderung an ein Design eines Gefriertrockners dar und limitiert in der Regel eine Menge an Wärme, welche den Produkten zugeführt oder entzogen werden kann. Aufgrund einer Beschaffenheit sowie Anordnung der Gefäße auf der Stellplatte ist es nahezu unmöglich, einen direkten Kontakt für eine Wärmeleitung zwischen den Gefäßen und den Stellplatten herzustellen. Ein Wärmetransport hängt also primär von einer Wärmeleitung durch ein Gas in der Trocknungskammer ab. Eine weitere Besonderheit der Wärmezufuhr ist es, dass die Wärme überwiegend durch einen Gefäßboden zugeführt wird. Dies hat einen Temperaturgradient im gefrorenen Produkt zur Folge, der während des Gefriertrocknungsprozesses bestehen bleibt. Eine Wärmezufuhr ist daher bei herkömmlichen Gefriertrocknern unter Vakuumbedingungen teilweise ineffizient und kann eine Gesamteffizienz des Gefriertrocknungsprozesses negativ beeinflussen.

Aus US 4,435,629 ist es bekannt, für eine Gefriertrocknung von Lebensmitteln eine Mikrowellenheizeinrichtung mit einem Oszillator und mit Leckwellenleitern vorzusehen, wobei zusätzlich zu einer Erwärmung mittels der Mikrowellen eine Erwärmung mittels Wärmerohren erfolgt, welche an den Leckwellenleitern vorgesehen sind.

### AUFGABE UND LÖSUNG

Es ist eine Aufgabe der vorliegenden Erfindung eine Vorrichtung und ein Verfahren zu schaffen, durch welche eine Effizienz des Gefriertrocknungsprozesses gesteigert werden kann.

Diese Aufgabe wird gelöst durch die Vorrichtung, das Verfahren und die Verwendung mit den Merkmalen der Ansprüche 1, 10 und 13. Vorteilhafte Ausgestaltungen sind in den Unteransprüchen beschrieben.

Gemäß einem ersten Aspekt wird eine Vorrichtung zum Gefriertrocknen von Produkten mit einer Trocknungskammer, in welcher Produkte für einen Gefriertrocknungsprozess anordenbar sind, geschaffen, wobei ein auf Halbleitertechnologie basierendes Mikrowellenmodul vorgesehen ist, mittels welchem Mikrowellen für eine Energiezufuhr in die in der Trocknungskammer angeordneten Produkte während des Gefriertrocknungsprozesses erzeugbar sind, wobei das Mikrowellenmodul mindestens eine außerhalb der Trocknungskammer angeordnete Mikrowellensteuerung, mindestens einen außerhalb der Trocknungskammer angeordneten Mikrowellengenerator und mindestens eine in der Trocknungskammer angeordnete, auf Halbleitertechnologie basierende Mikrowellenantenne umfasst.

Die Energiezufuhr dient insbesondere einem Temperieren der Produkte, vorzugsweise einem Erwärmen der Produkte für einen Trocknungsvorgang. Die Energiezufuhr mittels Mikrowellen erfolgt je nach Ausgestaltung zeitweise während des Gefriertrocknungsprozesses oder während des gesamten Gefriertrocknungsprozesses, wobei die zugeführte Energie variabel ist. In einer Ausgestaltung ist dabei vorgesehen, dass eine zugeführte Energie mit sinkender Restfeuchte in den Produkten reduziert wird.

Die Trocknungskammer ist durch den Fachmann geeignet gestaltbar. Insbesondere erfolgt eine Gestaltung derart, dass eine Strahlungsleckage an eine Umgebung vermieden wird. Zu diesem Zweck sind insbesondere an Schaugläsern, in Dichtungsbereichen von Türen oder dergleichen geeignete Abschirmungen vorgesehen.

Die erfindungsgemäße Energiezufuhr mittels Mikrowellen hat den Vorteil, dass die Energiezufuhr von Bedingungen in der Trocknungskammer, insbesondere einem herrschenden Druck, nicht oder zumindest weniger als bei herkömmlichen Methoden beeinflusst wird. Eine Energiezufuhr ist dabei unter anderem auch gegenüber herkömmlichen Methoden gleichmäßiger möglich, da die Energiezufuhr nicht überwiegend über den Gefäßboden erfolgt und somit weniger von einem Emissionsgrad des Produkts, üblicherweise gefrorenes Wasser mit einem geringen Emissionsgrad, abhängig ist.

Zur Erzeugung der Mikrowellen wird dabei mindestens ein auf Halbleitertechnologie basierendes Mikrowellenmodul eingesetzt. Dieses hat gegenüber einem Magnetron u.a. die Vorteile, dass weniger Komponenten erforderlich sind und ein Platzbedarf geringer ist. Der geringere Platzbedarf macht sich besonders bei einer Größe von Bauteilen bemerkbar, die die Mikrowellen erzeugen und abstrahlen.

Die Energiezufuhr mittels der Mikrowellen erfolgt je nach Ausgestaltung zusätzlich oder alternativ zu einer herkömmlichen Energiezufuhr, beispielsweise über in der Trocknungskammer angeordnete Stellplatten.

Das Mikrowellenmodul umfasst mindestens eine Mikrowellensteuerung, mindestens einen Mikrowellengenerator und mindestens eine auf Halbleitertechnologie basierende Mikrowellenantenne.

Je nach Anforderung ist beispielsweise eine Mikrowellensteuerung vorgesehen, welche signalübertragend mit einem oder mehreren Mikrowellengeneratoren verbunden ist, wobei mit jedem Mikrowellengenerator eine oder mehrere Mikrowellenantennen signalübertragend verbunden sind.

Die Mikrowellenantenne ist ein auf der Halbleitertechnologie basierendes Bauteil. Auf der Halbleitertechnologie basierte Mikrowellenantennen können im Vergleich zu Mikrowellenantennen, die nicht auf der Halbleitertechnologie basieren, kleiner ausgeführt sein. Weiter können sie unterschiedliche Ausgestaltungen aufweisen. Beispielsweise können auf der Halbleitertechnologie basierte Mikrowellenantennen als Leiterplattenantennen, als Schlitzantennen oder als Patch-Antennen ausgebildet sein. Bei elektrischer Anregung einer Mikrowellenantenne entwickelt diese ein elektromagnetisches Feld und strahlt Mikrowellen ab.

Unter dem Begriff Mikrowellenantenne ist im Rahmen dieses Dokuments eine auf der Halbleitertechnologie basierte Mikrowellenantenne zu verstehen, ansonsten ist im Folgenden gesondert darauf hingewiesen.

Die mindestens eine Mikrowellenantenne ist/sind an geeigneten Stellen in der Trocknungskammer anbringbar, um eine gleichmäßige Strahlungsverteilung zu erzielen. Die gleichmäßige Strahlungsverteilung kann auf eine gleichmäßige Verteilung in der Trocknungskammer gerichtet sein. In vorteilhaften Ausgestaltungen ist eine Anordnung der mindestens einen Mikrowellenantenne auf eine gleichmäßige Strahlungsverteilung der Mikrowellen auf die in der Trocknungskammer angeordneten Produkte gerichtet. In einer Ausgestaltung werden die Mikrowellenantennen alternativ oder zusätzlich mit einer Frequenzphasenschiebung betrieben, um eine Homogenität des Magnetfeldes zu gewährleisten.

In einer Ausgestaltung ist in der Trocknungskammer mindestens eine Stellplatte vorgesehen, auf welcher die Produkte für einen Gefriertrocknungsprozess platziert werden, wobei die zumindest eine Mikrowellenantenne angrenzend die mindestens eine Stellplatte, insbesondere angrenzend an einer Flachseite der mindestens einen Stellplatte, angeordnet ist. Die Stellplatte dient in einer Ausgestaltung einer Temperaturzufuhr und/oder einer Temperaturabfuhr. In anderen Ausgestaltungen dient die Stellplatte lediglich als Stellfläche für die Produkte. Im Unterschied zu herkömmlichen Vorrichtungen sind die Stellplatten in einer Ausgestaltung aus einem nichtmetallischen Material.

Als Flachseiten werden dabei eine Oberseite der Stellplatte, auf welcher die Produkte platziert werden, und eine gegenüberliegende Unterseite bezeichnet. Die Mikrowellenantenne ist dabei in einer Ausgestaltung an einer Unterseite der Stellplatte angeordnet, wobei eine Oberseite auf herkömmliche Weise mit die Produkte aufnehmenden Gefäßen für einen Wärmetransport nutzbar ist. Dabei ist in einer Ausgestaltung vorgesehen, dass die mindestens eine Mikrowellenantenne eine Ober- und/oder Unterseite der Stellplatte vollständig abdeckt.

Der Mikrowellengenerator und die Mikrowellensteuerung sind außerhalb der Trocknungskammer angeordnet. Dadurch ist es möglich, auf eine temperatur- und vakuumfeste Gestaltung des Mikrowellengenerators und der Mikrowellensteuerung zu verzichten. Weiter ist eine Zugänglichkeit des Mikrowellengenerators und der Mikrowellensteuerung erleichtert.

In einer Ausgestaltung ist die mindestens eine Mikrowellensteuerung mit einem übergeordneten Steuerungssystem und mindestens einem nachgeordneten Mikrowellengenerator signalübertragend verbunden.

Die Mikrowellensteuerung kommuniziert vorzugsweise zum einen mit dem übergeordneten Steuerungssystem und zum anderen mit dem mindestens einen Mikrowellengenerator. Die Kommunikation erfolgt je nach Ausgestaltung Kabel oder kabellos. Dabei ist die Mikrowellensteuerung in einer Ausgestaltung in dem übergeordneten Steuerungssystem der Vorrichtung integriert und sendet oder überträgt Signale an den mindestens einen Mikrowellengenerator. In einer bevorzugten Ausgestaltung ist eine separate Mikrowellensteuerung vorgesehen, welche jedoch mit dem übergeordneten Steuerungssystem zum Austausch von Daten und/oder Steuersignalen verbunden ist. Das übergeordnete Steuerungssystem ist in einer vorteilhaften Ausgestaltung das Steuerungssystem einer Gefriertrocknungsanlage und steuert den Gefriertrocknungsprozess.

Der mindestens eine Mikrowellengenerators ist mit mindestens einer Mikrowellenantenne signalübertragend verbunden. Der Mikrowellengenerator bestimmt dabei eine Frequenz und Leistung der mittels der Mikrowellenantenne abgestrahlten Mikrowelle. Die Frequenz und die Leistung der mittels der Mikrowellenantenne abgestrahlten Mikrowelle werden im Zusammenhang mit der Anmeldung als Ausgangsfrequenz bzw. Ausgangsleistung der Mikrowellenantenne bezeichnet.

Der Mikrowellengenerator verwertet und verstärkt vorzugsweise die Signale der Mikrowellensteuerung und generiert leistungsgebundene elektromagnetische Signale für die damit verbundenen Mikrowellenantennen. Die Mikrowellenantenne wandelt die leistungsgebundenen elektromagnetischen Signale des Mikrowellengenerators in Mikrowellen um und strahlt diese in der Trocknungskammer aus.

In einer Ausgestaltung ist eine Mikrowellenantenne wahlweise mittels unterschiedlicher Mikrowellengeneratoren signalempfangend verbindbar, wobei eine Ausgangsleistung und/oder einer Ausgangsfrequenz der Mikrowellenantenne von dem verbundenen Mikrowellengenerator abhängt.

In vorteilhaften Ausgestaltungen ist eine Ausgangsleistung und/oder einer Ausgangsfrequenz der mindestens einen signalübertragend mit dem Mikrowellengenerator verbundenen Mikrowellenantenne mittels des Mikrowellengenerators anpassbar. Ein Betreiben des Mikrowellenmoduls ist somit bei verschiedenen Arbeitspunkten möglich.

Mittels des Mikrowellengenerators ist die Ausgangsleistung und/oder die Ausgangsfrequenz der mindestens einen Mikrowellenantenne in einer Ausgestaltung in Stufen und/oder stufenlos anpassbar. Die Anpassung erfolgt dabei je nach Anwendungsfall ohne Rückmeldung des Ist-Zustands oder unter Rückmeldung des Ist-Zustands. Die Rückmeldung kann an die Mikrowellensteuerung und/oder an den Mikrowellengenerator erfolgen. Die Mikrowellensteuerung und/oder der Mikrowellengenerator kann dann Einfluss auf die Ausgangsleistung und/oder die Ausgangsfrequenz der mindestens einen Mikrowellenantenne nehmen. Dabei ist in einer Ausgestaltung vorgesehen, dass die Ausgangsfrequenz und/oder die Ausgangsleistung innerhalb eines definierten Bereichs anpassbar ist. Ein geeigneter Bereich ist dabei durch den Fachmann je nach Bauform der Vorrichtung und/oder Anforderungen an die Vorrichtung geeignet wählbar. In einer Ausgestaltung ist die Ausgangsleistung in einem Bereich zwischen ca. 10 W und ca. 100 W anpassbar. In anderen Ausgestaltungen sind je nach Anforderung an die Vorrichtung andere Bereiche vorgesehen. Alternativ oder zusätzlich ist in einer Ausgestaltung eine Ausgangsfrequenz in einem Bereich zwischen ca. 2.1 bis ca. 2.8GHz anpassbar. In anderen Ausgestaltungen sind andere Bereiche vorgesehen. Durch die anpassbare Ausgangsleistung und/oder die anpassbare Ausgangsfrequenz ist es möglich, eine Energiezufuhr zu variieren. In einer Ausgestaltung wird für eine Primärtrocknung die Energiezufuhr deutlich höher gewählt als für eine Sekundärtrocknung, wobei in einer Ausgestaltung eine Energiezufuhr bei der Sekundärtrocknung maximal 30%, insbesondere maximal 10% der Energiezufuhr bei der Primärtrocknung beträgt.

In einer Ausgestaltung ist ausschließlich ein Mikrowellengenerator vorgesehen. In vorteilhaften Ausgestaltungen sind mehrere Mikrowellengeneratoren vorgesehen, welche jeweils mit mindestens einer Mikrowellenantenne signalübertragend verbunden sind.

In einer Ausgestaltung ist der mindestens eine Mikrowellengenerators mit mehreren Mikrowellenantennen signalübertragend verbunden ist. Vorzugsweise sind dabei Ausgangsleistungen und/oder Ausgangsfrequenzen der signalübertragend verbundenen Mikrowellenantennen unabhängig voneinander mittels des Mikrowellengenerators anpassbar.

Unabhängig voneinander anpassbare Ausgangsleistungen und/oder Ausgangsfrequenzen mehrerer Mikrowellenantennen ermöglichen neben der gleichmäßigen Strahlungsverteilung auch eine bereichsabhängig anpassbare Intensität der Mikrowellen in der Trocknungskammer und somit eine bereichsabhängige Anpassung der Temperaturen der Produkte in der Trocknungskammer. In vorteilhaften Ausgestaltungen sind ein Abstrahlen der Mikrowellen und ein Einwirken der Mikrowellen je Produkt und Produktbereich anpassbar. Das heißt, es kann vorzugsweise eine Temperatur beeinflusst werden, die in dem jeweiligen Produktbereich eines Produkts herrschen soll.

In einer Ausgestaltung ist die mindestens eine Mikrowellensteuerung mit mehreren Mikrowellengeneratoren signalüberragend verbunden.

Je nach Gestaltung weist die Vorrichtung beispielsweise mehrere Mikrowellengeneratoren auf, welche jeweils mit einer, zwei oder mehreren Mikrowellenantennen signalübertragend verbunden sind. Jedem Mikrowellengenerator ist in einer Ausgestaltung eine eigene Mikrowellensteuerung zugeordnet. Eine Abstimmung zwischen den Mikrowellensteuerungen erfolgt dabei beispielsweise nur indirekt mittels des übergeordneten Steuerungssystems. In anderen Ausgestaltungen ist mehreren oder allen Mikrowellengeneratoren eine gemeinsame Mikrowellensteuerung zugeordnet. Die Mikrowellenantennen eines Mikrowellengenerators werden in einer Ausgestaltung gemeinsam angesteuert. In anderen Ausgestaltungen erfolgt eine Anpassung der Ausgangsleistung und/oder der Ausgangsfrequenz für jede Mikrowellenantenne eines Mikrowellengenerators individuell.

Die Vorrichtung umfasst weiter einen Kondensator. In einer Ausgestaltung ist der Kondensator in der Trocknungskammer angeordnet. In anderen Ausgestaltungen umfasst die Vorrichtung eine Kondensatorkammer, in welcher der Kondensator angeordnet ist. Die Trocknungskammer und die Kondensatorkammer sind dabei in vorteilhaften Ausgestaltungen derart angeordnet, dass ein Einkoppeln von Mikrowellen in die Kondensatorkammer verhindert wird. Alternativ oder zusätzlich sind die Trocknungskammer und die Kondensatorkammer zeitweise voneinander trennbar. Insbesondere ist in einer Ausgestaltung vorgesehen, dass eine Anschlussöffnung zwischen der Kondensatorkammer und der Trocknungskammer eine Abschirmung aufweist, welche ein Eindringen von Mikrowellen in das Innere der Kondensatorkammer verhindert.

Die Vorrichtung umfasst vorzugsweise weiter eine Vakuumpumpe, mittels welcher ein Druck in der Trocknungskammer absenkbar ist. Die Vakuumpumpe ist in einer Ausgestaltung unmittelbar mittels eines Ventils mit der Trocknungskammer verbunden. In anderen Ausgestaltungen ist die Trocknungskammer über die Kondensatorkammer mit der Vakuumpumpe fluidisch verbunden, wobei die Trocknungskammer und die Kondensatorkammer je nach Ausgestaltung permanent oder bedarfsweise trennbar miteinander verbunden sind.

Gemäß einem zweiten Aspekt wird ein Verfahren zum Gefriertrocknen von Produkten in einer Trocknungskammer geschaffen, wobei Produkte für einen Gefriertrocknungsprozess in der Trocknungskammer angeordnet werden, wobei den der in der Trocknungskammer angeordneten Produkte zumindest zeitweise während des Gefriertrocknungsprozesses Energie mittels Mikrowellen zugeführt wird, und wobei die Mikrowellen mittels mindestens eines auf Halbleitertechnologie basierenden Mikrowellenmoduls, umfassend mindestens eine außerhalb der Trocknungskammer angeordnete Mikrowellensteuerung, mindestens einen außerhalb der Trocknungskammer angeordneten Mikrowellengenerator und mindestens eine in der Trocknungskammer angeordnete, auf Halbleitertechnologie basierende Mikrowellenantenne, erzeugt werden.

Die mindestens eine Mikrowellenantenne ist in der Trocknungskammer angeordnet. Eine Energiezufuhr mittels Mikrowellen erfolgt in vorteilhaften Ausgestaltungen unter Vakuumbedingungen. Dabei erfolgt in einer Ausgestaltung ein Erwärmen der Produkte ausschließlich durch die Energiezufuhr mittels Mikrowellen. In anderen Ausgestaltungen erfolgt zusätzlich eine Wärmezufuhr über in der Trocknungskammer vorgesehene Wärmestrahler, insbesondere über Stellplatten.

In einer Ausgestaltung wird dabei eine Ausgangsleistung und/oder eine Ausgangsfrequenz der mindestens einen Mikrowellenantenne zumindest zeitweise während des Gefriertrocknungsprozesses variiert.

In einer Ausgestaltung werden die Mikrowellen mittels mehreren auf Halbleitertechnologie basierenden Mikrowellenantennen abgestrahlt, wobei Ausgangsleistungen und/oder Ausgangsfrequenzen der Mikrowellengeneratoren zumindest zweitweise während des Gefriertrocknungsprozesses unabhängig voneinander angepasst werden.

Gemäß einem dritten Aspekt ist eine Verwendung mindestens eines auf Halbleitertechnologie basierenden Mikrowellenmoduls, umfassend mindestens eine außerhalb der Trocknungskammer angeordnete Mikrowellensteuerung, mindestens einen außerhalb der Trocknungskammer angeordneten Mikrowellengenerator und mindestens eine eine in der Trocknungskammer angeordnete, auf Halbleitertechnologie basierende Mikrowellenantenne, zur Erzeugung von Mikrowellen für eine Energiezufuhr zu Produkten in einem Gefriertrocknungsprozess geschaffen.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind. Dabei zeigen:
- Fig. 1:: schematisch ein erstes Ausführungsbeispiel einer erfindungsgemäßen Vorrichtung zur Gefriertrocknung;
- Fig. 2:: schematisch ein zweites Ausführungsbeispiel einer erfindungsgemäßen Vorrichtung zur Gefriertrocknung; und
- Fig. 3:: schematisch ein drittes Ausführungsbeispiel einer erfindungsgemäßen Vorrichtung zur Gefriertrocknung.

### DETAILLIERTE BESCHREIBUNG DER AUSFÜHRUNGSBEISPIELE

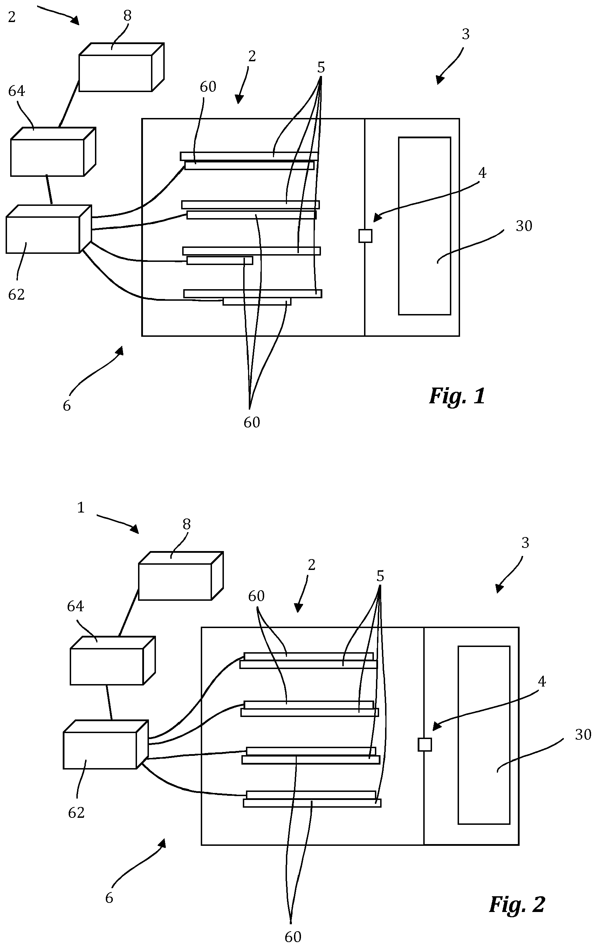

Fig.1 zeigt schematisch eine Vorrichtung 1 zum Gefriertrocknen umfassend eine Trocknungskammer 2 und eine Kondensatorkammer 3 mit einem Kondensator 30. Die Trocknungskammer und die Kondensatorkammer 3 sind in dem dargestellten Ausführungsbeispiel über ein Zwischenventil 4 verbunden. In anderen Ausgestaltungen ist kein Zwischenventil 4 vorgesehen. In wieder anderen Ausgestaltungen ist der Kondensator 30 in der Trocknungskammer 2 angeordnet.

In der Trocknungskammer 2 sind mehrere Stellplatten 5 vorgesehen, wobei in Fig. 1 beispielhaft vier Stellplatten 5 dargestellt sind. Die Anzahl der Stellplatten 5 kann jedoch je nach Anwendungsfall variieren. Produkte, welche dem Gefriertrocknungsprozess unterzogen werden sollen, werden beispielsweise in Vials (nicht dargestellt) auf den Stellplatten 5 platziert.

Die Vorrichtung 1 umfasst weiter ein auf Halbleitertechnologie basierendes Mikrowellenmodul 6 mit mehreren Mikrowellenantennen 60, einem Mikrowellengenerator 62 und einer Mikrowellensteuerung 64.

In dem dargestellten Ausführungsbeispiel ist nur ein Mikrowellengenerator 62 vorgesehen, wobei die Mikrowellenantennen 64 jeweils mit dem Mikrowellengenerator 62 signalempfangend verbunden sind. Die Anzahl und Anordnung der Mikrowellenantennen 62, die mit dem Mikrowellengenerator 62 verbunden sind, ist dabei je nach Anforderung durch den Fachmann geeignet wählbar. In einer Ausgestaltung sind alle in einer Vorrichtung 1 vorgesehenen Mikrowellenantennen 64 baugleich gestaltet. In anderen Ausgestaltungen sind die Mikrowellenantennen 64 einer Vorrichtung 1 - wie in Fig. 1 dargestellt - unterschiedlich gestaltet. In einer abweichenden Ausgestaltung sind mehrere Mikrowellengeneratoren 62 vorgesehen, wobei die Anzahl und/oder Anordnung der mit jeweils mit einem Mikrowellengenerator 62 verbundenen Mikrowellenantennen 64 unterschiedlich sein kann. Eine Ansteuerung des Mikrowellengenerators 62 erfolgt mittels der Mikrowellensteuerung 64. Sofern mehrere Mikrowellengeneratoren 62 vorgesehen sind, können diese jeweils einer eigenen Mikrowellensteuerung 64 oder gruppenweise oder insgesamt einer zentralen Mikrowellensteuerung 64 zugeordnet sein.

In dem in Fig. 1 dargestellten Ausführungsbeispiel sind die Mikrowellenantennen 60 jeweils angrenzend an eine Stellplatte 5 unterhalb der Stellplatte 5 angeordnet. Dabei ist in einer Ausgestaltung jeder Stellplatte 5 eine Mikrowellenantenne 60 zugeordnet. In anderen Ausgestaltungen sind - wie in Fig. 1 dargestellt - nur an einem Teil der Stellplatten 5 Mikrowellenantennen 60 vorgesehen.

Die Mikrowellenantennen 60 sind in der in Fig. 1 dargestellten Ausgestaltung über Leiter, wie beispielsweise Kabel, mit dem Mikrowellengenerator 62 verbunden. In anderen Ausgestaltungen kann eine Signalübertragung beispielsweise auch drahtlos ausgeführt sein. Die Ausgestaltung der Signalübertragung über Kabel - wie in Fig. 1 dargestellt - zwischen den einzelnen Mikrowellenantennen 64 und dem Mikrowellengenerator 62 erlauben eine Übertragung von leistungsgebundenen elektromagnetischen Signalen des Mikrowellengenerators 62 an die Mikrowellenantennen 64. Dabei sind eine Ausgangsleistung und/oder eine Ausgangsfrequenz durch den Mikrowellengenerator 62 anpassbar und die Mikrowellenantennen 64 strahlen infolgedessen Mikrowellen mit einer definierten Leistung und/oder Frequenz in der Trocknungskammer 2 ab.

Die Mikrowellengeneratoren 62 sind jeweils über eine Kommunikationsschnittstelle drahtlos und/oder mittels Leiter mit der Mikrowellensteuerung 64 verbunden.

Mittels der Mikrowellensteuerung 64 wird dem Mikrowellengenerator 62 kommuniziert, wie die Ausgangsleistung und/oder eine Ausgangsfrequenz der Mikrowellenantennen 64 anzupassen ist/sind. Dabei werden in einer Ausgestaltung Ausgangsleistungen und/oder Ausgangsfrequenzen aller Mikrowellenantennen 64 separat angepasst. In anderen Ausgestaltungen erfolgt eine gruppenweise Anpassung, wobei Mikrowellenantennen 64 in einer Gruppe mit einem Mikrowellengenerator 62 verbunden sind oder auf mehrere Mikrowellengeneratoren 62 verteilt sind.

Die Vorrichtung 1 weist vorzugsweise weiter nicht dargestellte, aus herkömmlichen Vorrichtungen zum Gefriertrocknen bekannte Einrichtungen auf, wie ein Kühl-/Heizmodul zum Temperieren der Stellplatten 5 und/oder eines Wärmeübertragers des Kondensators 30, ein Vakuummodul für die Evakuierung der Trocknungskammer 2 und/oder ein Belüftungssystem, welches beispielsweise sowohl einer Belüftung der Vorrichtung 1 als auch einer Druckanpassung während des Gefriertrocknungsprozesses dient.

Die Vorrichtung 1 umfasst ein übergeordnetes Steuerungssystem 8, wobei in dem dargestellten Ausführungsbeispiel die Mikrowellensteuerung 64 mit dem übergeordneten Steuerungssystem 8 zum Austausch von Daten und/oder Steuerungssignalen verbunden ist.

Das übergeordnete Steuerungssystem 8 ist beispielsweise als SCADA-System ausgeführt. Es dient insbesondere der Steuerung und Überwachung relevanter Prozessschritte des Gefriertrocknungsprozesses einschließlich von Nebenprozessschritten, wie beispielweise einer automatischen Reinigung und Sterilisation.

Der Gefriertrocknungsprozess umfasst beispielsweise folgende Prozessschritte:
1. Produkt beladen
2. Produkt kühlen, einfrieren und unterkühlen bis zu einer spezifischen Temperatur
3. Evakuieren bis zu einem definierten Druck
4. Produkt auf eine definierte Temperatur erwärmen
5. Produkt verschließen (nötig, falls das Produkt in verschließbaren Gefäßen gefriergetrocknet wurde, beispielweise Glasgefäße mit Stopfen)
6. Produkt entladen
7. Vorbereiten des Gefriertrockners für den nächsten Prozess.

Erfindungsgemäß wird zumindest zweitweise während des Gefriertrocknungsprozesses den in der Trocknungskammer 2 angeordneten Produkten Energie über Mikrowellen zugeführt, die mittels des auf Halbleitertechnologie basierenden Mikrowellenmoduls 6, das mindestens eine auf Halbleitertechnologie basierende Mikrowellenantenne 64 umfasst, erzeugt werden. Die Energiezufuhr kann dabei je nach Anwendungsfall beispielsweise eine Energiezufuhr durch herkömmliches Temperieren der Stellplatten 5 ersetzen oder ergänzen.

Vorzugsweise erfolgt eine Energiezufuhr über einen Strahlungswärmeeintrag der Mikrowellen zumindest für ein Erwärmen der Produkte unter Vakuum.

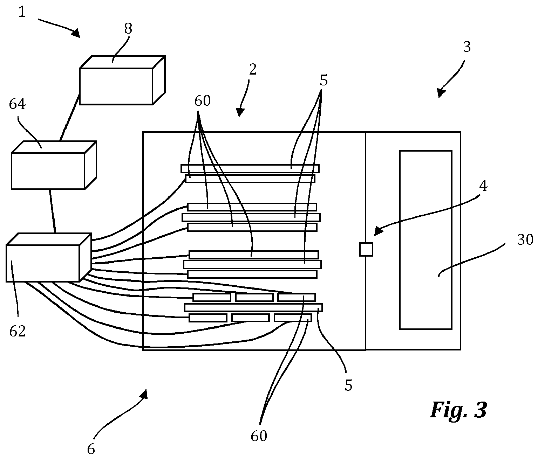

Fig. 2 und 3 zeigen zwei weitere Ausführungsbeispiele von Vorrichtungen 1 zum Gefriertrocknen mit auf Halbleitertechnologie basierenden Mikrowellenantennen 64 zur Erzeugung von Mikrowellen für eine Energiezufuhr zu in Trocknungskammern 2 vorhandenen Produkten.

Die Vorrichtungen 1 gemäß den Fig. 2 und 3 sind ähnlich der Vorrichtung 1 gemäß Fig. 1. Für gleiche oder ähnliche Bauteile werden übereinstimmende Bezugszeichen verwendet und für eine Beschreibung wird auf oben verwiesen.

Die Mikrowellenantennen 64 sind dabei ebenfalls jeweils mit mindestens einem Mikrowellengenerator 62 verbunden. Im Unterschied zu der Gestaltung gemäß Fig. 1 sind bei der Vorrichtungen 1 gemäß Fig. 2 die Mikrowellenantennen 62 oberhalb der Stellplatten 5 an diese angrenzend angeordnet. Bei der Vorrichtungen 1 gemäß Fig. 3 sind die Mikrowellenantennen 64 sowohl oberhalb als auch unterhalb der Stellplatten 5 an diese angrenzend angeordnet.

In dem in Fig. 3 dargestellten Ausführungsbeispiel sind an einer Stellplatte 5, in der Zeichnung der untersten Stellplatte 5, mehrere Mikrowellenantennen 64 vorgesehen, die sowohl oberhalb als auch unterhalb der einen untersten Stellplatte 5 angeordnet sind. Jede dieser Mikrowellenantennen ist separat mit dem Mikrowellengenerator 62 verbunden. Die Darstellung ist lediglich beispielhaft. Abweichend können auch an mehreren oder allen Stellplatten 5 in einer Ausgestaltung mehrere Mikrowellenantennen 64 vorgesehen sein.

In allen dargestellten Ausführungsbeispielen sind die Mikrowellenantennen 64 in einer Trocknungskammer 2 angeordnet und mit mindestens einem außerhalb der Trocknungskammer 2 angeordneten Mikrowellengenerator 62 signalempfangend verbunden. Die Mikrowellenantennen 64 sind dabei auf oder unter den Stellplatten 5 angebracht. Diese Ausgestaltung ist vorteilhaft, da eine einfache Montage möglich ist. Zudem ist es möglich, bereits bestehende Vorrichtungen entsprechend mittels der Mikrowellenantennen 64 auszustatten. Es sind jedoch auch andere Gestaltungen denkbar, bei welchen die Mikrowellenantennen 64 beispielsweise in die Stellplatten 5 und/oder in Wandungselemente der Trocknungskammer 2 integriert sind.

Die dargestellten Ausführungsbeispiele sind lediglich beispielhaft und beschränken nicht die durch die Ansprüche definierten Gegenstände. Insbesondere ist die Größe der Trocknungskammer 2 und die Anzahl der Stellplatten 5 sowie eine Anordnung und Anzahl der Mikrowellenantennen 64 an den Stellplatten 5, die Anzahl der Mikrowellengeneratoren 62 und deren Anbindung an die Mikrowellenantennen 64 sowie die Anzahl der Mikrowellensteuerungen 64 lediglich beispielhaft.

## Patentansprüche

1. Vorrichtung zum Gefriertrocknen von Produkten mit einer Trocknungskammer (2), in welcher Produkte für einen Gefriertrocknungsprozess anordenbar sind, wobei ein Mikrowellenmodul vorgesehen ist, mittels welchem Mikrowellen für eine Energiezufuhr in die in der Trocknungskammer (2) angeordneten Produkte während des Gefriertrocknungsprozesses erzeugbar sind, **dadurch gekennzeichnet, dass** als Mikrowellenmodul ein auf Halbleitertechnologie basierendes Mikrowellenmodul (6) vorgesehen ist, wobei das Mikrowellenmodul (6) mindestens eine Mikrowellensteuerung (64), mindestens einen Mikrowellengenerator (62) und mindestens eine auf Halbleitertechnologie basierende Mikrowellenantenne (60) umfasst, wobei die mindestens eine Mikrowellenantenne (60) in der Trocknungskammer (2) angeordnet ist und wobei der mindestens eine Mikrowellengenerator (62) und die mindestens eine Mikrowellensteuerung (64) außerhalb der Trocknungskammer (2) angeordnet sind.

2. Vorrichtung nach Anspruch 1, **dadurch gekennzeichnet, dass** in der Trocknungskammer (2) mindestens eine Stellplatte (5) vorgesehen ist, auf welcher die Produkte für einen Gefriertrocknungsprozess platziert werden, wobei die mindestens eine Mikrowellenantenne (60) angrenzend an die mindestens eine Stellplatte (5) angeordnet ist.

3. Vorrichtung nach Anspruch 2, **dadurch gekennzeichnet, dass** die Mikrowellenantenne (60) an einer Flachseite der mindestens einen Stellplatte (5) angeordnet ist.

4. Vorrichtung nach Anspruch 1, 2 oder 3, **dadurch gekennzeichnet, dass** die mindestens eine Mikrowellensteuerung (64) mit einem übergeordneten Steuerungssystem (8) und mindestens einem nachgeordneten Mikrowellengenerator (62) signalübertragend verbunden ist.

5. Vorrichtung nach Anspruch einem der Ansprüche 1 bis 4, **dadurch gekennzeichnet, dass** der mindestens eine Mikrowellengenerators (62) mit der mindestens einen Mikrowellenantenne (60) signalübertragend verbunden ist, wobei eine Ausgangsleistung und/oder einer Ausgangsfrequenz der mindestens einen signalübertragend verbundenen Mikrowellenantenne (60) mittels des mindestens einen Mikrowellengenerators (62) anpassbar ist.

6. Vorrichtung nach Anspruch 5, **dadurch gekennzeichnet, dass** die Ausgangsleistung und/oder die Ausgangsfrequenz der mindestens einen Mikrowellenantenne (60) im Betrieb der Vorrichtung in Stufen und/oder stufenlos anpassbar ist.

7. Vorrichtung nach Anspruch 4 oder 5, **dadurch gekennzeichnet, dass** der mindestens eine Mikrowellengenerators (62) mit mehreren Mikrowellenantennen (60) signalübertragend verbunden ist, wobei Ausgangsleistungen und/oder Ausgangsfrequenzen der signalübertragend verbundenen Mikrowellenantennen (60) unabhängig voneinander mittels des Mikrowellengenerators (62) anpassbar sind.

8. Vorrichtung nach einem der Anspruch 1 bis 7, **dadurch gekennzeichnet, dass** die mindestens eine Mikrowellensteuerung (64) mit mehreren Mikrowellengeneratoren (62) signalüberragend verbunden ist.

9. Vorrichtung nach einem der Ansprüche 1 bis 8, **dadurch gekennzeichnet, dass** eine Kondensatorkammer (3) mit einem Kondensator (30) vorgesehen ist, wobei die Trocknungskammer (2) und die Kondensatorkammer (3) derart zueinander angeordnet sind, dass ein Einkoppeln von Mikrowellen in die Kondensatorkammer (3) verhindert oder zumindest minimiert ist.

10. Verfahren zum Gefriertrocknen von Produkten, wobei Produkte für einen Gefriertrocknungsprozess in einer Trocknungskammer (2) angeordnet werden,
wobei den der in der Trocknungskammer (2) angeordneten Produkte zumindest zeitweise während des Gefriertrocknungsprozesses Energie mittels Mikrowellen zugeführt wird,
**dadurch gekennzeichnet, dass**
die Mikrowellen mittels eines auf Halbleitertechnologie basierenden Mikrowellenmoduls (6), umfassend mindestens eine außerhalb der Trocknungskammer (2) angeordnete Mikrowellensteuerung (64), mindestens einen außerhalb der Trocknungskammer (2) angeordneten Mikrowellengenerator (62) und mindestens eine auf Halbleitertechnologie basierende, in der Trocknungskammer (2) angeordnete Mikrowellenantenne (60), erzeugt werden.

11. Verfahren nach Anspruch 10, **dadurch gekennzeichnet, dass** eine Ausgangsleistung und/oder eine Ausgangsfrequenz der mindestens einen Mikrowellenantenne (60) zumindest zeitweise während des Gefriertrocknungsprozesses variiert wird.

12. Verfahren nach Anspruch 10, **dadurch gekennzeichnet, dass** Mikrowellen mittels mehreren auf Halbleitertechnologie basierenden Mikrowellenantennen (60) abgestrahlt werden, wobei Ausgangsleistungen und/oder Ausgangsfrequenzen der Mikrowellenantennen (60) zumindest zweitweise während des Gefriertrocknungsprozesses unabhängig voneinander angepasst werden.

13. Verwendung mindestens eines auf Halbleitertechnologie basierenden Mikrowellenmoduls (6), umfassend mindestens eine außerhalb der Trocknungskammer (2) angeordnete Mikrowellensteuerung (64), mindestens einen außerhalb der Trocknungskammer (2) angeordneten Mikrowellengenerator (62) und mindestens eine auf Halbleitertechnologie basierende, in der Trocknungskammer (2) angeordnete Mikrowellenantenne (60), zur Erzeugung von Mikrowellen für eine Energiezufuhr zu Produkten in einem Gefriertrocknungsprozess gemäß Anspruch 10.

## Claims

1. Device for freeze-drying products having a drying chamber (2), in which products can be arranged for a freeze-drying process, wherein a microwave module is provided, by means of which microwaves can be generated for supplying energy to the products arranged in the drying chamber (2) during the freeze-drying process, **characterized in that** a microwave module (6) based on semiconductor technology is provided as the microwave module, wherein the microwave module (6) comprises at least one microwave control unit (64), at least one microwave generator (62) and at least one microwave antenna (60) based on semiconductor technology, wherein the at least one microwave antenna (60) is arranged in the drying chamber (2) and wherein the at least one microwave generator (62) and the at least one microwave control unit (64) are arranged outside the drying chamber (2) .

2. Device according to Claim 1, **characterized in that** at least one shelf (5) is provided in the drying chamber (2), on which at least one shelf the products are placed for a freeze-drying process, wherein the at least one microwave antenna (60) is arranged adjacent to the at least one shelf (5).

3. Device according to Claim 2, **characterized in that** the microwave antenna (60) is arranged on a flat side of the at least one shelf (5).

4. Device according to Claim 1, 2 or 3, **characterized in that** the at least one microwave control unit (64) is connected to a higher-level control system (8) and at least one lower-level microwave generator (62) for signal transmission.

5. Device according to any one of Claims 1 to 4, **characterized in that** the at least one microwave generator (62) is connected to the at least one microwave antenna (60) for signal transmission, wherein an output power and/or an output frequency of the at least one microwave antenna (60) connected for signal transmission are/is adjustable by means of the at least one microwave generator (62).

6. Device according to Claim 5, **characterized in that** the output power and/or the output frequency of the at least one microwave antenna (60) are/is adjustable incrementally and/or continuously during operation of the device.

7. Device according to Claim 4 or 5, **characterized in that** the at least one microwave generator (62) is connected to a plurality of microwave antennas (60) for signal transmission, wherein output powers and/or output frequencies of the microwave antennas (60) connected for signal transmission are adjustable independently of one another by means of the microwave generator (62).

8. Device according to any one of Claims 1 to 7, **characterized in that** the at least one microwave control unit (64) is connected to a plurality of microwave generators (62) for signal transmission.

9. Device according to any one of Claims 1 to 8, **characterized in that** a condenser chamber (3) with a condenser (30) is provided, wherein the drying chamber (2) and the condenser chamber (3) are arranged relative to each other so as to prevent or at least minimize the coupling of microwaves into the condenser chamber (3).

10. Method for freeze-drying products, wherein products are arranged in a drying chamber (2) for a freeze-drying process,
wherein energy is supplied to the products arranged in the drying chamber (2) by means of microwaves, at least at times during the freeze-drying process,
**characterized in that**
the microwaves are generated by means of a microwave module (6) based on semiconductor technology, comprising at least one microwave control unit (64) arranged outside the drying chamber (2), at least one microwave generator (62) arranged outside the drying chamber (2) and at least one microwave antenna (60) based on semiconductor technology and arranged in the drying chamber (2).

11. Method according to Claim 10, **characterized in that** an output power and/or an output frequency of the at least one microwave antenna (60) are/is varied at least at times during the freeze-drying process.

12. Method according to Claim 10, **characterized in that** microwaves are emitted by means of a plurality of microwave antennas (60) based on semiconductor technology, wherein output powers and/or output frequencies of the microwave antennas (60) are adjusted independently of each other at least at times during the freeze-drying process.

13. Use of at least one microwave module (6) based on semiconductor technology, comprising at least one microwave control unit (64) arranged outside the drying chamber (2), at least one microwave generator (62) arranged outside the drying chamber (2) and at least one microwave antenna (60) based on semiconductor technology and arranged in the drying chamber (2), for generating microwaves for supplying energy to products in a freeze-drying process according to Claim 10.

## Revendications

1. Dispositif de lyophilisation de produits comprenant une chambre de séchage (2), dans laquelle des produits peuvent être disposés pour un processus de lyophilisation, un module à micro-ondes étant présent, au moyen duquel peuvent être générées des micro-ondes pour un apport d'énergie dans les produits disposés dans la chambre de séchage (2) pendant le processus de lyophilisation, **caractérisé en ce que** le module à micro-ondes présent est un module à micro-ondes (6) basé sur la technologie des semiconducteurs, le module à micro-ondes (6) comportant au moins une commande de micro-ondes (64), au moins un générateur de micro-ondes (62) et au moins une antenne à micro-ondes (60) basée sur la technologie des semiconducteurs, l'au moins une antenne à micro-ondes (60) étant disposée dans la chambre de séchage (2) et l'au moins un générateur de micro-ondes (62) et l'au moins une commande de micro-ondes (64) étant disposés à l'extérieur de la chambre de séchage (2).

2. Dispositif selon la revendication 1, **caractérisé en ce qu'**au moins une plaque de support (5) est présente dans la chambre de séchage (2), sur laquelle sont placés les produits pour un processus de lyophilisation, l'au moins une antenne à micro-ondes (60) étant disposée de manière adjacente à l'au moins une plaque de support (5).

3. Dispositif selon la revendication 2, **caractérisé en ce que** l'antenne à micro-ondes (60) est disposée sur un côté plat de l'au moins une plaque de support (5).

4. Dispositif selon la revendication 1, 2 ou 3, **caractérisé en ce que** l'au moins une commande de micro-ondes (64) est reliée avec transmission de signaux à un système de commande (8) de niveau supérieur et à au moins un générateur de micro-ondes (62) disposé en aval.

5. Dispositif selon l'une des revendications 1 à 4, **caractérisé en ce que** l'au moins un générateur de micro-ondes (62) est relié avec transmission de signaux à l'au moins une antenne à micro-ondes (60), une puissance de sortie et/ou une fréquence de sortie de l'au moins une antenne à micro-ondes (60) avec transmission de signaux pouvant être adaptée au moyen de l'au moins un générateur de micro-ondes (62).

6. Dispositif selon la revendication 5, **caractérisé en ce que** la puissance de sortie et/ou la fréquence de sortie de l'au moins une antenne à micro-ondes (60) est adaptable par paliers et/ou en continu pendant le fonctionnement du dispositif.

7. Dispositif selon la revendication 4 ou 5, **caractérisé en ce que** l'au moins un générateur de micro-ondes (62) est relié avec transmission de signaux à plusieurs antennes à micro-ondes (60), les puissances de sortie et/ou les fréquences de sortie des antennes à micro-ondes (60) reliées avec transmission de signaux pouvant être adaptées indépendamment les unes des autres au moyen du générateur de micro-ondes (62).

8. Dispositif selon l'une des revendications 1 à 7, **caractérisé en ce que** l'au moins une commande de micro-ondes (64) est reliée avec transmission de signaux à plusieurs générateurs de micro-ondes (62).

9. Dispositif selon l'une des revendications 1 à 8, **caractérisé en ce qu'**une chambre de condensateur (3) pourvue d'un condensateur (30) est présente, la chambre de séchage (2) et la chambre de condensateur (3) étant disposées l'une par rapport à l'autre de telle sorte qu'une injection de micro-ondes dans la chambre de condensateur (3) est empêchée ou au moins réduite au minimum.

10. Procédé de lyophilisation de produits, des produits étant disposés dans une chambre de séchage (2) pour un processus de lyophilisation,
de l'énergie étant acheminée au moyen de micro-ondes aux produits disposés dans la chambre de séchage (2) au moins temporairement pendant le processus de lyophilisation,
**caractérisé en ce que**
les micro-ondes sont générées au moyen d'un module à micro-ondes (6) basé sur une technologie à semiconducteurs, comprenant au moins une commande de micro-ondes (64) disposée à l'extérieur de la chambre de séchage (2), au moins un générateur de micro-ondes (62) disposé à l'extérieur de la chambre de séchage (2) et au moins une antenne à micro-ondes (60) basée sur une technologie à semiconducteurs et disposée dans la chambre de séchage (2).

11. Procédé selon la revendication 10, **caractérisé en ce qu'**une puissance de sortie et/ou une fréquence de sortie de l'au moins une antenne à micro-ondes (60) est modifiée au moins temporairement pendant le processus de lyophilisation.

12. Procédé selon la revendication 10, **caractérisé en ce que** des micro-ondes sont émises au moyen de plusieurs antennes à micro-ondes (60) basées sur la technologie des semiconducteurs, les puissances de sortie et/ou les fréquences de sortie des antennes à micro-ondes (60) étant adaptées indépendamment les unes des autres au moins temporairement pendant le processus de lyophilisation.

13. Utilisation d'au moins un module à micro-ondes (6) basé sur une technologie à semiconducteurs, comprenant au moins une commande de micro-ondes (64) disposée à l'extérieur de la chambre de séchage (2), au moins un générateur de micro-ondes (62) disposé à l'extérieur de la chambre de séchage (2) et au moins une antenne à micro-ondes (60) basée sur une technologie à semiconducteurs et disposée dans la chambre de séchage (2), destinée à générer des micro-ondes pour un apport d'énergie à des produits dans un processus de lyophilisation selon la revendication 10.
